# EUROPEAN PATENT APPLICATION

(11) **EP 2 159 869 A1**
(43) Date of publication of application: **03.03.2010**
(21) Application number: 08777057.4
(22) Date of filing: 30.05.2008
(51) Int. Cl.: H01M 14/00, H01L 31/04, H01M 2/22

(54) **DYE-SENSITIZED SOLAR BATTERY MODULE AND METHOD FOR MANUFACTURING THE SAME**

(30) Priority: 06.06.2007 JP 2007150338
(71) Applicant: Fujikura, Ltd., Tokyo 135-8512 (JP)
(72) Inventor: OKADA, Kenichi, Tokyo 135-8512 (JP); KITAMURA, Takayuki, Tokyo 135-8512 (JP); MATSUI, Hiroshi, Tokyo 135-8512 (JP)
(74) Representative: Cabinet Plasseraud
(86) International application number: PCT/JP2008/060046
(87) International publication number: WO 2008/149811

(57) **Abstract**

The present invention discloses a dye-sensitized solar cell module 20, in which a dye-sensitized solar cell including a first conductive layer 11, porous semiconductor layers 12, 13, and a second conductive layer 15 is plurally aligned between a base material 10 and a back side plate 17. An end of the second conductive layer 15 is electrically connected by the end of the second conductive layer 15 being fixed relative to the first conductive layer 11 of a dye-sensitized solar cell 20b which is adjacent to a dye-sensitized solar cell 20a to which the second conductive layer 15 belongs. A portion of the second conductive layer 15 placed above the porous semiconductor layers 12, 13 is not bonded with the porous semiconductor layers 12, 13 or the back side plate 17. In accordance with the present invention, in the dye-sensitized solar cell module, it is possible to restrain a decrease in durability of a film of a counter electrode with regard to thermal expansion and contraction of each of the layers due to the thermal history to a bending, a distortion, or the like.

## Description

### [TECHNICAL FIELD]

The present invention relates to a dye-sensitized solar cell module and a production method thereof.
Priority is claimed on Japanese Patent Application No. 2007-150338, filed on June 6, 2007, the content of which is incorporated herein by reference.

### [BACKGROUND ART]

As a method of connecting adjacent cells in the Dye-Sensitized Solar Cell (hereinbelow also called DSC), a method of combining a counter electrode with a wiring in series (which is called monolithic module among DSC researchers) is known.

Patent Document 1 discloses a photovoltaic cell battery which is formed of a monolithic assembly including a plurality of photovoltaic elements connected in series and disposed on a common transparent substrate as elongated stripes. Each of the elements has a photoanode provided with a porous layer of a polycrystalline semiconductor and a back plate formed of a porous layer of conductive material and separated from the photoanode by an intermediate porous layer of an electrically insulated material. Holes of the porous layer are filled with charge transport electrolyte.

Patent Document 2 discloses, as a first embodiment, a dye-sensitized solar cell in which silica-beads are interposed between: a photoelectrode formed of a transparent conductive layer and a semiconductor electrode formed on a transparent substrate; and a counter electrode formed of a carbon electrode formed on a substrate. An electrolyte is filled between the photoelectrode and the counter electrode. Also, as a third embodiment of the Patent Document 3, a monolithic module is disclosed in which a space between the photoelectrode and the counter electrode is a porous layer. In this case, it is described that the porous layer and the carbon electrode can also be formed by a method in which a paste is applied on the semiconductor electrode one after the other.

Patent Document 3 discloses that a dye-sensitized solar cell is preferable in which an electrode substrate formed of a base material and a first conductive layer provided on a side of the base material, a porous semiconductor layer provided on the first conductive layer in series in a laminated manner, a porous insulator layer, and a cell structure formed of a second conductive layer, in which an electrolyte solution is included in the porous semiconductor layer and the porous insulator layer.
Patent document 1: Published Japanese Translation No. H11-514787 of the PCT International Publicatrion
Patent Document 2: Japanese Unexamined Patent Application, First Publication No. 2004-127849
Patent Document 3: Japanese Unexamined Patent Application, First Publication No. 2006-236960

### [DISCLOSURE OF THE INVENTION]

### [PROBLEM TO BE SOLVED BY THE INVENTION]

As described above, in the conventional monolithic dye-sensitized solar cell module, the most of them are manufactured by: forming a porous titanium oxide (semiconductor) layer on a base material transparent conductive glass, subsequently forming a separator, and simultaneously forming an interconnect between the counter electrode and a working electrode of an adjacent cell. This is followed by holding pigment, impregnating an electrolyte solution, and sealing with an overcoating. A module manufactured in this method has the following problems.

(1) Since layers formed between the transparent conductive glass and the counter electrode are laminated, they are bonded with each other and are integrated.
(2) Since each layer of the photoelectrode and the counter electrode is formed on a layer which is formed in the previous processes as a foundation, it is necessary to form the layers with materials and by a method which do not degrade those foundations. Also, before each layer of the photoelectrode and the counter electrode is formed, the materials need to be precursors which can be applied such as ink or paste.
(3) Although each of the layers is bonded, the bond strength between the layers or in the layers is low, thereby having low durability with regard to a distortion.
(4) Impure substances tend to remain in the porous electrodes, thereby having the possibility of having low electric power-generation efficiency.

In Patent Document 2, as a first embodiment, a production method is disclosed in which a photoelectrode formed in the transparent substrate and a counter electrode formed in the back side of the substrate face each other, and the silica-beads and the electrolyte are filled between the photoelectrode and the counter electrode. In this case, although the counter electrode is not formed with the photoelectrode as a foundation, durability of the counter electrode decreases when there is a difference in coefficient of thermal expansion of the counter electrode and the back side of the substrate or there is a bending or a distortion in the substrate, since the counter electrode is bonded to the back side of the substrate.

The present invention was made in view of the above-described circumstances. An object of the invention is to provide a dye-sensitized solar cell module and a production method thereof, which is capable of restraining a decrease in durability of a film of a counter electrode with regard to thermal expansion and contraction of each of the layers of the photoelectrode and the counter electrode due to a thermal history and to a bending or a distortion in each of the substrates of the transparent substrate and the back side substrate.

### [MEANS FOR SOLVING THE PROBLEM]

In order to achieve the above-described object, the present invention provides a dye-sensitized solar cell module which includes: a base material; a back side plate provided so as to face the base material; and a plurality of a dye-sensitized solar cells provided in parallel between the base material and the back side plate, in which the dye-sensitized solar cell includes: a first conductive layer provided on the base material; a second conductive layer provided on the back side plate so as to face the first conductive layer; and a porous semiconductor layer provided between the first conductive layer and the second conductive layer. In addition, by electrically connecting the second conductive layer belonging to a first dye-sensitized solar cell with an adjacent first electrode layer which is the first conductive layer of another dye-sensitized solar cell adjacent to the first dye-sensitized solar cell, the plurality of dye-sensitized solar cells are electrically connected in series, in which an area of the second conductive layer overlapping the porous semiconductor layer seen from the back side plate is not bonded with the porous semiconductor layer or the back side plate.

In the dye-sensitized solar cell module of the present invention, it is preferable that the second conductive layer be held in the dye-sensitized solar cell by an area except the overlapping area in the first conductive layer of the adjacent dye-sensitized solar cell being bonded with the first conductive layer of the adjacent dye-sensitized solar cell.
It is preferable that, the area of the second conductive layer except the overlapping area in the first conductive layer of the adjacent dye-sensitized solar cell is further bonded with the back side plate.
It is preferable that the second conductive layer is a conductive member provided as a film.
It is preferable that the second conductive layer is divided in a direction in which the dye-sensitized solar cells are aligned.
It is preferable that the second conductive layer is connected with the adjacent first conductive layer via a conductive connection member.

The present invention provides a production method of a dye-sensitized solar cell module which includes: a substrate preparation process for preparing a base material and an electrode substrate provided with a plurality of first conductive layers formed on a side of the base material; a semiconductor layer forming process for forming a porous semiconductor layer on each of the conductive layers of the electrode substrate; a second electrode layer placement process for placing a second conductive layer above the porous semiconductor layer so as not to bond with the porous semiconductor layer; a conductive layer bonding process for bonding and electrically connecting the second conductive layer with an adjacent first electrode layer which is a first conductive layer of another dye-sensitized solar cell which is adjacent to a first dye-sensitized solar cell to which the second conductive layer belongs; and a back side plate placement process for placing a back side plate above the second conductive layer so that an area of the second conductive layer placed above the porous semiconductor layer does not bond with the back side plate; and a lysate filling process for filling the inside of the porous semiconductor layer with an electrolyte solution.

It is preferable that, in the production method of the dye-sensitized solar cell module, the second conductive layer is a conductive member provided as a film.
It is preferable that, in the conductive layer bonding process, a conductive connection member is provided on the adjacent first conductive layer so as to protrude upward from an upper surface of the porous semiconductor layer, and an end of the second conductive layer is bonded with an upper surface of the connection member.
It is preferable that, in the second electrode layer placement process, a conductive member provided as a film corresponding to a size of the electrode substrate is placed so as to cover a plurality of the porous semiconductor layers, and in the conductive layer bonding process, said one conductive member provided as a film is cut after an end portion of the area of said one conductive member provided as a film corresponding to the dye-sensitized solar cell is bonded and electrically connected with the first conductive layer of another adjacent dye-sensitized solar cell.

### [EFFECT OF THE INVENTION]

In accordance with the present invention, an area of the second conductive layer, which is the counter electrode, overlapping the porous semiconductor layer seen from the back side plate, is not bonded with the back side plate and the porous semiconductor layer. Therefore, even if each of the layers of the photoelectrode and the counter electrode are made of materials having different thermal expansion coefficients, stress does not occur between the photoelecterode and the counter electrode due to the difference in the thermal expansion coefficient. Even if external force such as bending or distortion is applied to each of the substrates, namely the transparent substrate and the back side substrate, the external force does not reach the counter electrode. Therefore, the second conductive layer can restrain a decrease in durability of the film of the counter electrode with regard to thermal expansion and contraction of each of the layers due to the thermal history and to the bending or the distortion in each of the substrates.

### [BRIEF DESCRIPTION OF DRAWINGS]

FIG. 1 is a schematic cross-sectional view showing an example of a dye-sensitized solar cell module in accordance with the present invention.
FIG. 2 is a schematic cross-sectional view showing an example of a substrate having a first conductive layer on a side of a base material.
FIG. 3 is a schematic cross-sectional view showing an example of an electrode substrate having a plurality of the first conductive layers disposed separate from each other on a side of the base material.
FIG. 4 is a plane view of the electrode substrate shown in FIG. 3.
FIG. 5 is an explanatory view for a process of forming a first porous semiconductor layer on each of the first conductive layers of the electrode substrate.
FIG. 6 is an explanatory view for a process of forming a second conductive porous semiconductor layer on the first porous semiconductor layer.
FIG. 7 is an explanatory view for a process of forming a connection member on the first conductive layer.
FIG. 8 is an explanatory view for a process in which a conductive film, which is to be the second conductive layer, is placed above the porous semiconductor layer so as not to bond therewith, and is fixed on an upper surface of the connection member.
FIG. 9 is an explanatory view for a process in which the conductive film is cut, and the second conductive layer, which corresponds to each of the dye-sensitized solar cells, is formed.
FIG. 10 is a plane view of the substrate in a state shown in FIG. 9.
FIG. 11 is an explanatory view for a process in which pigment is held in the porous semiconductor layer.
FIG. 12 is an explanatory view for a process in which a back side plate is disposed.
FIG. 13 is an explanatory view for a process in which an electrolyte solution is filled inside of the porous semiconductor layer.

### [BRIEF DESCRIPTION OF THE REFERENCE NUMERALS]

- 10:: base material
- 11:: first conductive layer
- 12:: first pigment held porous semiconductor layer
- 13:: second pigment held porous semiconductor layer
- 14:: connection member
- 15:: conductive film (second conductive layer)
- 16:: division member
- 17:: back side plate
- 17a:: electrolyte solution filling opening
- 18:: sealing member
- 19:: electrolyte solution
- 20:: solar cell module
- 20a, 20b:: solar cell

### [BEST MODE FOR CARRYING OUT THE INVENTION]

Preferred embodiments of the present invention shall be described with reference to the drawings.

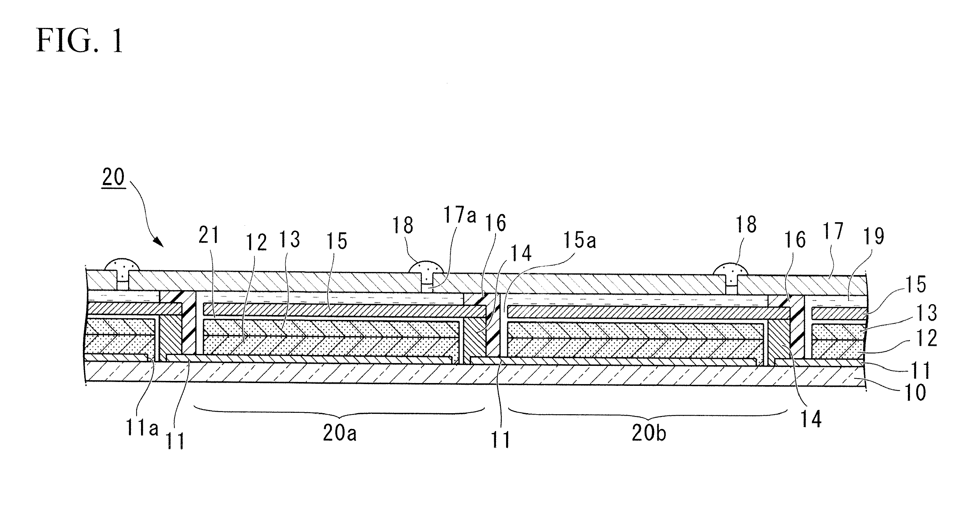

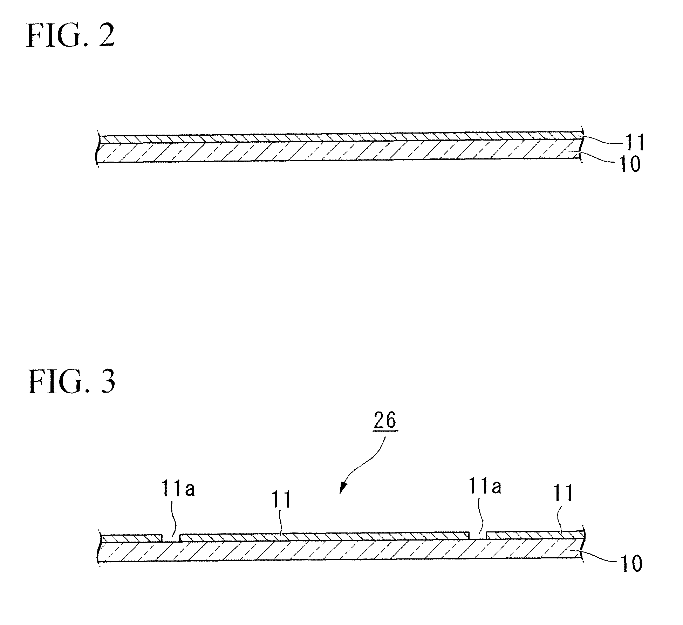

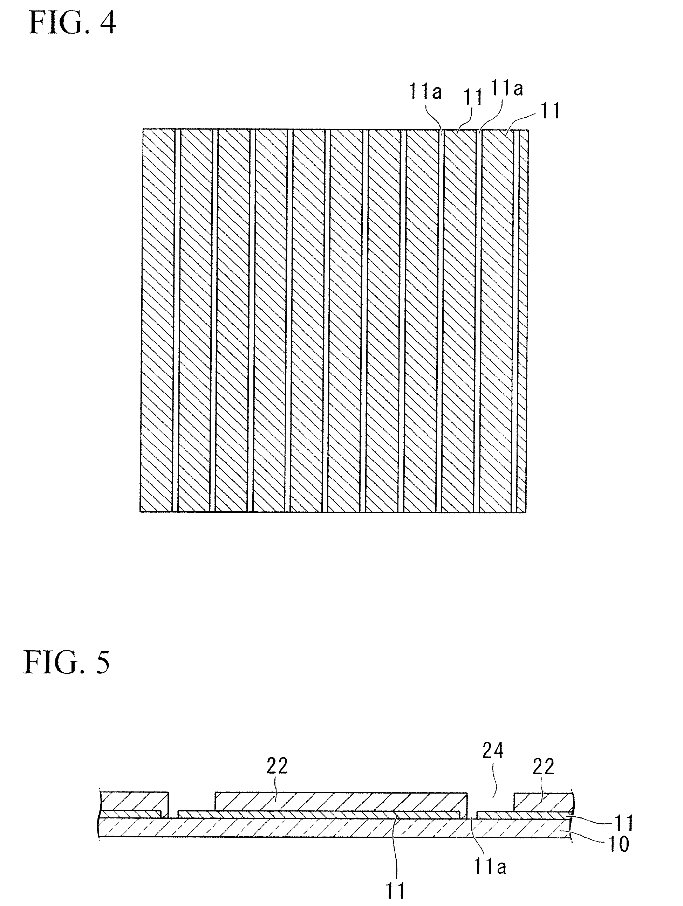

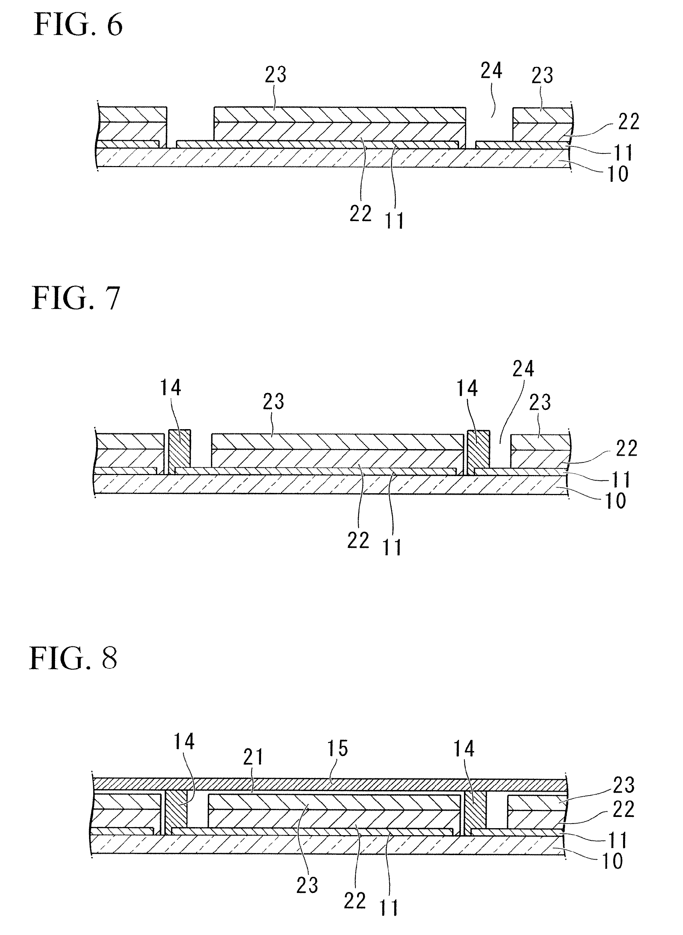

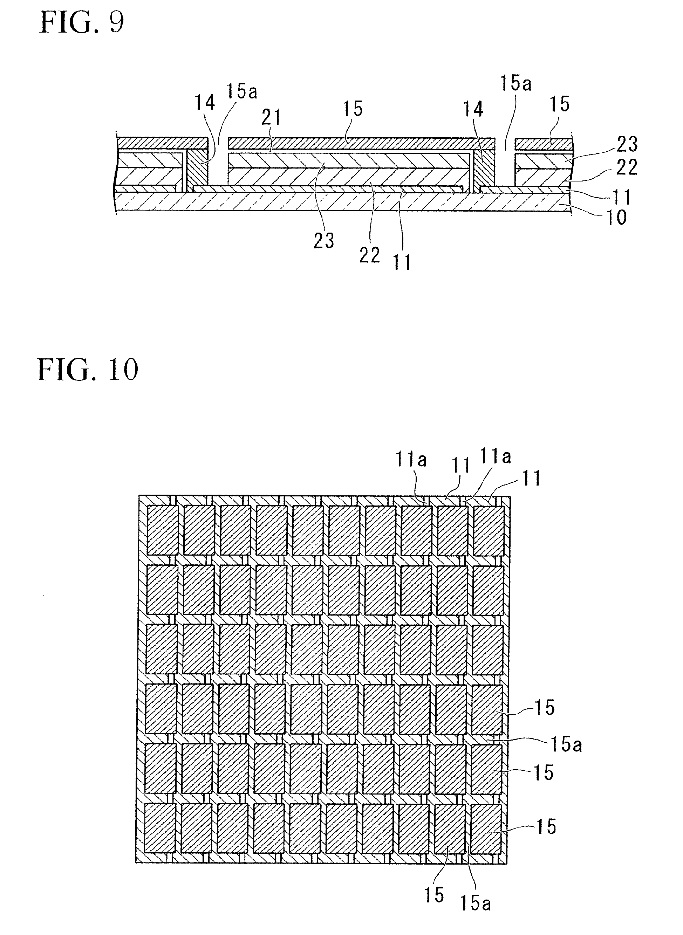

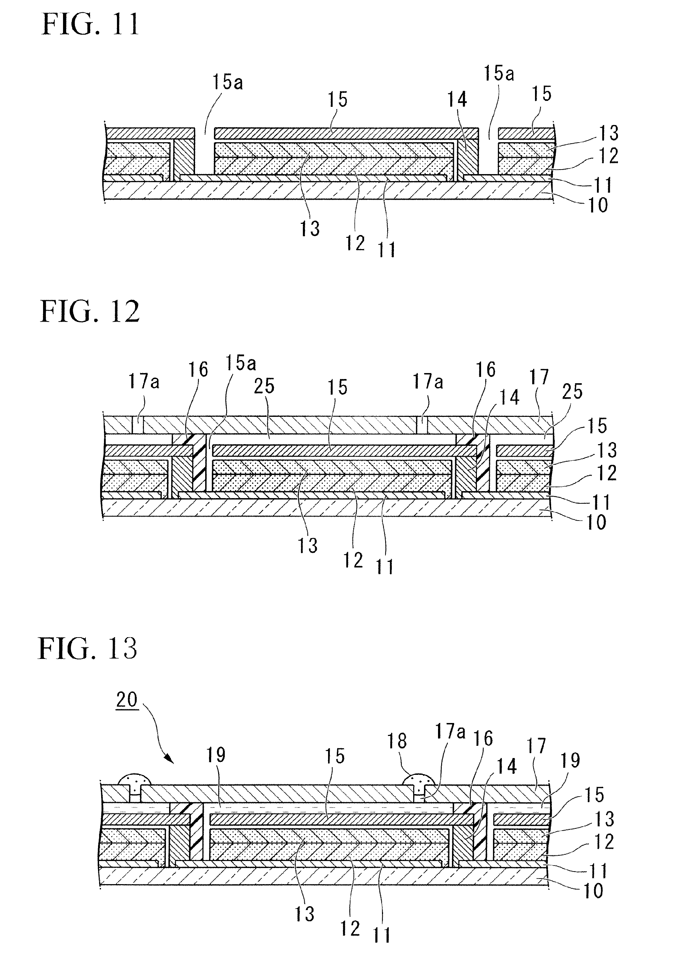

FIG. 1 is a schematic cross-sectional view showing an example of a dye-sensitized solar cell module in accordance with the present invention. FIG. 2 is a schematic cross-sectional view showing an example of a substrate having a first conductive layer on a side of a base material. FIG. 3 is a schematic cross-sectional view showing an example of an electrode substrate having a plurality of the first conductive layers disposed separate from each other on a side of the base material. FIG. 4 is a plane view of the electrode substrate shown in FIG. 3. FIG. 5 is an explanatory view for a process of forming a first porous semiconductor layer on each of the first conductive layers of the electrode substrate. FIG. 6 is an explanatory view for a process of forming a second conductive porous semiconductor layer on the first porous semiconductor layer. FIG. 7 is an explanatory view for a process of forming a connection member on the first conductive layer. FIG. 8 is an explanatory view for a process in which a conductive film, which is to be the second conductive layer, is placed above the porous semiconductor layer so as not to bond therewith, and is fixed on an upper surface of the connection member. FIG. 9 is an explanatory view for a process in which the conductive film is cut, and the second conductive layer, which corresponds to each of the dye-sensitized solar cells, is formed. FIG. 10 is a plane view of the substrate in a state shown in FIG. 9. FIG. 11 is an explanatory view for a process in which pigment is held in the porous semiconductor layer. FIG. 12 is an explanatory view for a process in which a back side plate is disposed. FIG. 13 is an explanatory view for a process in which an electrolyte solution is filled inside of the porous semiconductor layer.

A dye-sensitized solar cell module 20 in accordance with the present embodiment shown in FIG. 1 is provided with an electrode substrate having a base material 10 and a plurality of first conductive layers 11 disposed separate from each other on a side of the base material 10, porous semiconductor layers 12, 13 provided on the first conductive layers 11 of the electrode substrate in a laminated manner, a second conductive layer 15 provided above the porous semiconductor layers 12, 13, and a back side plate 17 provided facing the electrode substrate.

Between the base material 10 and the back side plate 17, a plurality of dye-sensitized solar cells 20a, 20b having said one first conductive layer 11 on the base material 10, the porous semiconductor layers 12, 13 provided on the first conductive layer 11, and the second conductive layer 15 provided above the porous semiconductor layers 12, 13 are provided in a line. Each of the dye-sensitized solar cells 20a, 20b is electrically connected in series. A division member 16 made of, for example, resin or a low melting point glass (insulating body) is provided between each of the dye-sensitized solar cells 20a, 20b. An electrolyte solution 19 is filled in a space between the base material 10 and the back side plate 17. The electrolyte solution 19 is filled inside of the porous semiconductor layers 12, 13. On the back side plate 17, an opening 17a for filling the electrolyte solution 19 is provided on each of the dye-sensitized solar cells 20a, 20b. The opening 17a is sealed with a sealing member 18 so as to be liquid tight.

An end of the second conductive layer 15 is fixed relative to the first conductive layer 11 of the dye-sensitized solar cell which is adjacent to the dye-sensitized solar cell, to which the second conductive layer 15 belonged. For example, an end of the second conductive layer 15 which is belonged to the dye-sensitized solar cell 20a is fixed relative to the first conductive layer 11 of the adjacent dye-sensitized solar cell 20b. Therefore, all dye-sensitized solar cells are electrically connected in series.

A part of the second conductive layer 15 which is placed above the porous semiconductor layers 12, 13 is not bonded with the porous semiconductor layers 12, 13 and the back side plate 17. That is, an area of the second conductive layer 15 which overlaps the porous semiconductor layers 12, 13 when it is seen from the back side plate 17, is not bonded with the porous semiconductor layers 12, 13 and the back side plate 17. Therefore, even if each of the layers of the porous semiconductor layers 12, 13 and the second conductive layer 15 are made of materials having different thermal expansion coefficients, stress does not occur between the porous semiconductor layers 12, 13 and the second conductive layer 1 due to the difference in the thermal expansion coefficient. Even if external force such as bending or distortion is applied to each of the substrates, namely a electrode substrate 26 and the back side substrate 17, the external force does not reach the second conductive layer 15. Therefore, the second conductive layer 15 can prevent a bad effect from applying which occurs when thermal expansion and contraction of each of the layers due to the thermal history or a bending or distortion in the substrates is occurred. As a result, it is possible to restrain a decrease in durability of the second conductive layer 15. Another end portion 15a of the second conductive layer 15 which is opposite to one end portion (fixed end) which is fixed to the first conductive layer 11 may be fixed to another member (for example, division member 16) or may not be fixed. Among these, it is preferable that the other end portion 15a of the second conductive layer 15 is not fixed to another member but is a free end. That is, it is preferable that the second conductive layer is held in the dye-sensitized solar cell by an area of the second conductive layer 15 which does not overlap the porous semiconductor layer 12 of the first conductive layer 11 connected electrically being bonded with the first conductive layer 15. Electrical connection between the second conductive layer 15 and the first conductive layer 11 and holding the second conductive layer 15 can be reliably performed. It is possible to further restrain a decrease in durability of the second conductive layer 15.

In the dye-sensitized solar cell module of the present embodiment, the second conductive layer 15 is formed in advance to be able to cover the upper surface of the porous semiconductor layers 12, 13.

It is preferable that a conductive material provided as a film is used for the second conductive layer 15. By using a self-organized film for the second conductive layer 15, it is possible to prevent a deterioration of a photoelectrode since a degrading gas does not occur in the film forming process compared to a conventional second conductive layer 15 in which the film is formed on the photoelectrode. As a conductive material, carbon-based conductive material such as carbon or graphite is used. The carbon-based conductive material can be preferably used since it is excellent in chemical stability relative to an electrolyte solution including halogen such as iodine or bromine. Also, foils of conductive metals excellent in corrosion resistivity such as a platinum foil or a titanium foil, in which a platinum film is formed on the surface, can be used. Graphite provided as a film, that is, a graphite sheet, has a rupture strength, which is varied from 0.5 MPa to 20MPa depending on samples, thereby being preferable as the second conductive layer 15. Electric resistivity of the graphite sheet is about 0.02 to 0.1 Ω/sq at about 50 µm of thickness which is excellent in conductivity compared to a normal conductive layer using a carbon paste (about 30 Ω/sq at about 50 µm of thickness).

An end of the second conductive layer 15 and the first conductive layer 11 of the adjacent dye-sensitized solar cell may be directly bonded and electrically connected, or may be connected via the conductive connection member 14. In order to further reliably bond each of the conductive layers 11, 15, connecting them via the conductive connection member 14 is preferable. A member with relatively high electrical resistivity may be used for the connection member 14. The connection member 14 can be made of a conductive adhesive or a conductive paste for example, in which conductive particles, a tying agent (such as resin or ceramic), or the like are mixed.

In the case of the dye-sensitized solar cell module 20 of the present embodiment, the connection member 14 is protruded on the first conductive layer 11 so that the height of the connection member 14 from the first conductive layer 11 is greater than the thickness of the porous semiconductor layers 12, 13. An end of the second conductive layer 15 is fixed to the upper surface of the connection member 14.

The base material 10 is not limited as long as it is made of a material with high optical transparency. As the base material 10, a glass plate is generally used but other materials may be used. The other materials include a plastic sheet such as polyethylene terephthalate (PET), polyethylene naphthalate (PEN), or polycarbonate (PC), or a ceramic grinding plate such as titanium oxide or alumina, or the like. A conductive heat resistance glass capable of withstanding about 500 °C is preferably used for the base material 10, if titanium dioxide (TiO₂) is heated to make the porous semiconductor during the process of forming the porous semiconductor. The thickness of the base material 10 is 1 to 4 mm for example but is not limited.

The first conductive layer 11 is a conductive film with high optical transparency, which is formed on a side of the base material 10. As the first conductive layer 11, a transparent oxide semiconductor such as tin doped indium tin oxide (ITO), tin oxide (SnO₂), or fluorine doped tin oxide (FTO) may be used. They may be used independently or may be used as a compound made of plurality thereof. By forming a conductive layer on a side of the base material 10 and forming slits 11a at intervals on the conductive layer so as to correspond to each of the dye-sensitized solar cell, it is possible to produce an electrode substrate provided with a plurality of the first conductive layers 11.

The porous semiconductor layers 12, 13 are made by holding pigments in the porous semiconductor. As a material for the porous semiconductor, titanium dioxide (TiO₂), tin oxide (SnO₂), tungsten oxide (WO₃), zinc oxide (ZnO), niobium oxide (Nb₂O₅), or the like are used for example. One or more than one of those oxides as a compound may be used. The porous semiconductor has a lot of fine holes which are formed by sintering raw materials with average particle diameter 6 to 50nm including the above-described oxide particles, for example. The pigments are held in the porous semiconductor layers 12, 13 and the electrolyte solution 19 is filled inside of the holes. The porous semiconductor layer may have a layer or a plurality of layers. When the porous semiconductor has two layers, it is preferable that the porous semiconductor layer 13 which is mixed with light scattering particles is formed on the side of the counter electrode (the second conductive layer), and the porous semiconductor layer 12 which is not mixed with light scattering particles is formed on the side of the window (base material). Accordingly, since the light entered from the window is scattered by the light scattering particles, the light absorbing efficiency by the porous semiconductor layer is improved. As the light scattering particles, titanium oxide particles of about 300nm in diameter can be employed for example.

As the pigments held on the porous semiconductor layers 12, 13, ruthenium complex, iron complex, metallic complex of porphyrin serues or phthalocyanine series, organic pigment such as eosin, rhodamine, merocyanine, coumalin, or the like can be employed. These are arbitrarily selected in accordance with usage or material of the porous semiconductor layer.

As the electrolyte solution 19, a solution in which an electrolyte is dissolved in a solvent or a liquid made of the electrolyte such as an ionic liquid may be used. As the ionic liquid, quaternized imidazolium salt, quaternized pyridinium salt, quaternized ammonium salt, or the like can be employed. When the solvent is used for the electrolyte solution 19, an organic solvent such as methoxyacetonitrile, acetonitrile, propionitrile, ethylene carbonate, γ-butyrolactone can be sited.
A redox pair is included in the electrolyte solution 19. As the redox pair, iodine/iodide ion, bromine/bromide ion, or the like can be employed. Various additives can be added in the electrolyte solution 19 if necessary.

The back side plate 17 may be transparent or not transparent, and its material is not limited. As the back side plate 17, a glass plate is generally used but other materials may be used. As the other materials, a plastic sheet or a film of polyethylene terephthalate (PET), polyethylene naphthalate (PEN), polycarbonate (PC), or the like or a ceramic grinding plate such as titanium oxide or alumina, a sheet in which a metal foil and a plastic film is adhered, or the like may be used. The thickness of the back side plate 17 is 1 to 4 mm but is not limited for the glass plate for example.

As the sealing member 18, a resin or the like can be used. As the resin, it is preferable to use an ultraviolet curing resin but is not limited thereto. By using the ultraviolet curing resin, it is not necessary to heat during curing, thereby causing less damage to the pigments which are vulnerable to heat.

The division member 16 is made by bonding the second conductive layer 15 with the back side plate 17. That is, the division member 16 is provided between the area of the second conductive layer 15 which is not overlapping the porous semiconductor layer 12 and the back side plate 17. The division plate 16 bonds the area of the second conductive layer 15 which is not overlapping the porous semiconductor layer 12 with the back side plate 17. Accordingly, it is possible to further reliably hold the second conductive layer 15 in the dye-sensitized solar cell. As the division member 16, a hot melt resin (hot melt adhesives) such as ionomer, an insulating body such as an ultraviolet curing resin or a low melting point glass, or the like can be used. When a material which can be formed at a temperature lower than the upper temperature limit of the pigments such as the resin is used, the division member 16 can be formed after the pigments being held in the porous semiconductor layer. When the division member 16 is formed at a temperature higher than the upper temperature limit of the pigments, the division member 16 is formed before the pigments being held in the porous semiconductor layer.

Next, a production method of the dye-sensitized solar cell module in accordance with the present embodiment shall be described.
As shown in FIG. 3, the base material 10 and the electrode substrate made of the plurality of the first conductive layers 11 provided on a side of the base material 10 are prepared. In order to produce such an electrode substrate, as shown in FIG. 2, a method can be employed in which a substrate is prepared wherein the first conductive layer 11 is formed over the whole surface of said one side of the base material 10 and the slits 11 a are formed on the first conductive layer 11. When forming the first conductive layer 11 on said one side of the base material 11, a method, in which a patterning is performed so that the slits 11 a are initially formed, can also be employed.

The method of forming the first conductive layer 11 on said one side of the base material 10 can be arbitrarily selected in accordance with the material of the first conductive layer 11. For example, a thin film made of the oxide semiconductor such as ITO, FTO, or SnO₂ is formed by a spattering method, a chemical vapor deposition (CVD) method, a spray pyrolysis deposition (SPD) method, a deposition method, or the like. Preferably, the film thickness of the first conductive layer 11 is about 0.1 to 1 µm, for example, when placing importance on both the optical transparency function and the conductivity function. If the first conductive layer 11 is too thick, it has less optical transparency, and if the first conductive layer 11 is too thin, it has less conductivity.

A forming method of the slit 11a is arbitrarily selected in accordance with the material of the first conductive layer 11. For example, excimer laser, air jet, water jet, etching, or mechanical processing can be employed. Accordingly, as shown in FIG. 4, the first conductive layer 11 is divided into a plurality of areas provided as stripes (rectangles). The pitch of the slit 11a is arbitrarily selected in accordance with the size of the dye-sensitized solar cell.

Next, porous semiconductor layers 22, 23 are formed on the first conductive layer 11. Here, the pigments are not held in the porous semiconductor layers 22, 23. In FIGS. 5 to 9, in order to distinguish from the porous semiconductor layers 12, 13 in which the pigments are held, different reference symbols are used for the porous semiconductor layers 22, 23 in which the pigments are not held.

The porous semiconductor layers 22, 23 can be formed by performing a patterning relative to the oxide semiconductor paste including titanium oxide fine particles by using print processes such as a screen printing method or an ink jet printing method, and heating to a temperature necessary for the sintering of the fine particles. When laminating the porous semiconductor layer 22 without the light scattering particles and the porous semiconductor layer 23 with the light scattering particles, as shown in FIG. 5, the oxide semiconductor paste without the light scattering particles is first printed and sintered, and then the porous semiconductor layer 22 is formed. Thereafter, as shown in FIG. 6, the oxide semiconductor paste with the light scattering particles is printed and sintered on the porous semiconductor layer 22, and the porous semiconductor layer 23 can be formed.

Next, as shown in FIG. 7, the conductive connection member 14 is provided on the first conductive layer 11 in a protruding manner. The height from the electrode substrate is greater than the thickness of the porous semiconductor layers 22, 23. Preferably, the connection member 14 is formed by using the conductive paste. As the conductive paste, carbon particles, binder, and solvent as the conductive particles, and carbon paste, in which other necessary additives being kneaded to be a paste, can be employed.

As the carbon paste, a paste in which an inorganic bonding agent precursor, isomerisum mixed terpineol, graphite powder, and ethylcellulose are blended in a mass ratio of 0.02 to 0.2: 1: 0.02 to 0.2: 0.02 to 0.2 or a paste in which an inorganic bonding agent precursor, ethyl carbitol, graphite powder, ethylcellulose, and toluene are blended in a mass ratio of 0.02 to 0.2: 1: 0.02 to 0.2: 0.02 to 0.2: 0.01 to 0.1 can be employed.

By forming the connection member 14 using the above-described conductive paste, placing the second conductive layer 15 before burning the connection member 14, and burning the conductive paste with the second conductive layer 15 abutting the connection member 14, it is possible to easily fix the connection member 14 to the second conductive layer 15. By arbitrarily providing a clearance 24 of the dye-sensitized solar cell, it is possible to assure a width for the connection member 14. Therefore, it is possible to sufficiently obtain a joint strength with the second conductive layer 15 and a conductivity of inter-cell connection via the connection member 14.
Here, in the present invention, when the second conductive layer 15 and the first conductive layer 11 are directly connected, the forming of the connection member 14 can be omitted.

Next, as shown in FIG. 8, the second conductive layer 15 is placed above the porous semiconductor layers 22, 23 so as not to bond with the porous semiconductor layers 22, 23. At this time, a portion 21 between the second conductive layer 15 and the porous semiconductor layers 22, 23 may be abutting or separated as long as the second conductive layer 15 and the porous semiconductor layers 22, 23 are not bonded.

It is preferable that when placing the second conductive layer 15 above the porous semiconductor layers 22, 23, the conductive member provided as a film is used for the second conductive layer 15. When placing the second conductive layer 15, the size of the conductive member provided as a film may be adjusted to correspond to the size of the first dye-sensitized solar cell in advance. Or the conductive member provided as a film with a size corresponding to the size of the base material 10 of the electrode substrate may be used. When using the conductive member provided as a film with a size corresponding to the size of the base material 10, after placing the conductive member provided as a film on the porous semiconductor layers 22, 23, the conductive member provided as a film is cut so as to correspond to the size of the first dye-sensitized solar cell. In this case, since it is possible to adjust the size of the conductive member provided as a film to a size corresponding to the size of the first dye-sensitized solar cell, it is possible to further improve the location accuracy of the second conductive layer 15.

Next, an end of the second conductive layer 15 of the dye-sensitized solar cell is fixed relative to a first conductive layer 11 of the adjacent dye-sensitized solar cell, and the second conductive layer 15 and the first conductive layer 11 are electrically connected. As described above, when the connection member 14 is formed by using the conductive paste, it is possible to fix the second conductive layer 15 on the upper surface of the connection member 14 by heating the conductive paste with the second conductive layer 15 being abutted the connection member 14. In order to increase the joint strength between the second conductive layer 15 and the connection member 14, it is preferable that the second conductive layer 15 and the connection member 14 are pressed together when heating the conductive paste.

As the second conductive layer 15 shown in FIG. 8, when the conductive member provided as a film having a size which is adjusted to correspond to the size of the first dye-sensitized solar cell is used, it is necessary to align the position of the second conductive layer 15 so that the end portion of each of the second conductive layers 15 is fixed to the upper surface of each of the connection members 14 when the second conductive layers 15 are fixed to the connection members 14. On the other hand, in the present embodiment, the conductive member provided as a film with a size corresponding to the size of the base material 10 of the electrode substrate is used. Accordingly, it is possible to employ a procedure in which the conductive member provided as a film is placed and fixed so as to cover all of the porous semiconductor layers 22, 23. Thereafter, the conductive member provided as a film is cut corresponding to the size of each of the dye-sensitized solar cells. Therefore, alignment of the position of the second conductive layers 15 relative to each of the dye-sensitized solar cells is not necessary, workability increases, and location accuracy increases.

FIG. 10 is a plane view showing the substrate after the conductive member provided as a film is cut. In order to cut the conductive member provided as a film and form each of the second conductive layers 15 with each of the dye-sensitized solar cells, it is at least necessary to form a slit 15a along the direction in which the slit 11a of the first conductive layer 11 extends. As a method of forming the slit 15a in the conductive member provided as a film, excimer laser, air jet, water jet, etching, mechanical processing, or the like can be employed.

Also, in this example, the slit 15a is also formed in a direction perpendicular to the direction the slit 11a extends. That is, the second conductive layer 15 is divided. in a direction where the plurality of the dye-sensitized solar cells is aligned. In FIG. 10, the conductive layer 15 is divided in 6 pieces per a dye-sensitized solar cell. Each of the second conductive layers aligned in vertical direction in FIG. 10 belongs to the same cell. In this manner, by the second conductive layer 15 belonging to the dye-sensitized solar cell and being divided in a plurality of portions, stress applied to the second conductive layer 15 is dispersed. Accordingly, it is possible to further improve the durability of the second conductive layer 15.

In order to make the pigments held in the porous semiconductor layers 22, 23, it is possible to employ a method in which a whole module structure is immersed in the pigment liquid. Preferably, the immersion process is performed after the second conductive layer 15 is fixed to the first conductive layer 11, and before the back side plate 17 is provided above the second conductive layer 15. Accordingly, heat generated during burning is not added to the pigments, it is possible to prevent the pigments from being damaged. Also, it is possible that cleaning to remove extra pigment solution after holding pigments, drying the solvent, or the like are easily performed.

Next, as shown in FIG. 12, after the division member 16 is formed in a clearance between the cells on the electrode substrate, the back side plate 17 is bonded with the electrode substrate via the division member 16. The division member 16 can be formed by applying the hot melt adhesives in the direction of the slit 11a of the first conductive layer 11.

In the present embodiment, the division member 16 is formed in a portion in which the first conductive layer 11 and the second conductive layer 15 are connected between each of the dye-sensitized solar cells. The division member 16 is provided from said one end of the second conductive layer 15 to a lateral portion of the connection member 14. Accordingly, it is possible to further improve the joint strength between the second conductive layer 15 and the connection member 14. Also, between the adjacent dye-sensitized solar cells 20a, 20b, it is possible to prevent an electron generated by photoelectric conversion from moving from the second conductive layer 15 of the dye-sensitized solar cell 20b, a clearance 21, the porous semiconductor layer 13, the porous semiconductor layer 12, or the first conductive layer 11 to the connection member 14 of the cell 20a and returning to the second conductive layer 15 of the cell 20b. Furthermore, when the second conductive layer 15 and the connection member 14 are made of porous material, it is possible to prevent the component of the electrolyte solution 19 from moving to the inside of the porous material and changing the composition.

The free end of the second conductive layer 15 is formed so as not to abut the division member 16. The division member 16 is formed so as to cover the upper surface of the second conductive layer 15 and to protrude from the upper surface of the second conductive layer 15. When the hot melt additives are used as the division member 16, by placing the back side plate 17 above the division member 16 and heating up to the temperature in which the hot melt additives soften with the back side plate 17 abutting the division member 16, it is possible to fix the back side plate 17.
Accordingly, the area of the second conductive layer 15 placed above the porous semiconductor layers 12, 13 does not abut the back side plate 17. A space 25, into which the electrolyte solution 19 (refer FIG. 13) is filled, is formed between the base material 10 and the back side plate 17.

Next, as shown in FIG. 13, the electrolyte solution 19 is filled inside of the openings of the porous semiconductor layers 12, 13. The filling of the electrolyte solution 19 can be performed by filling the electrolyte solution 19 from the filling opening 17a provided on the back side plate 17 and impregnating the porous semiconductor layers 12, 13 with the electrolyte solution 19. After filling the electrolyte solution 19, the filling opening 17a is sealed so as to be liquid tight by the sealing member 18 made of resin or the like and the space 25 filled with the electrolyte solution 19 is sealed.
In accordance with the above-described processes, dye-sensitized solar cell module 20 (refer FIG. 1) can be produced.

Here, in the above-described embodiment, descriptions were made for the dye-sensitized solar cell in which the pigments are held in the porous semiconductor layer. However, the idea of the present invention can be applied to a case in which the pigments are not held in the porous semiconductor layer as long as it is a wet solar cell using the electrolyte solution.

### [Examples]

Hereinbelow, the present invention shall be described in detail referring to the following examples. Note that the present invention is not limited to the following examples.

### <Example 1>

### [Production of a working electrode]

(A) An electrode substrate formed with a plurality of transparent conductive films (first conductive layer) provided as stripes with a width of about 1cm width is prepared by cleaning a 10 cm square glass substrate with FTO transparent conductive film (Made by ASAHI GLASS CO., LTD., product name: A110U80R, surface resistivity: 10 Ω/sq) and forming a slit with a pitch of about 1 cm using the excimer laser apparatus.

(B) A porous titanium oxide film having a thickness of about 10 µm is formed by forming a film with titanium oxide paste (Made by Solaronix SA, product name: Ti-nanoxide T/sp) as a stripe of about 9 mm in width on the upper surface of the transparent conductive layer so as to expose a lateral border portion of the transparent conductive layer by the screen printing method and burning at 500 °C.

(C) In the same way, a porous titanium oxide film is formed by forming a film with titanium oxide paste including the light scattering particles (Made by Solaronix SA, product name: Ti-nanoxide D/sp) as a stripe having a width of about 9 mm on the porous titanium oxide film in a laminated manner by the screen printing method and heating at 500 °C. At this time, the film thickness of two layers of the porous titanium oxide film is 20µm.

### [Preparation of a graphite sheet (conductive member provided as a film)]

(A) A graphite sheet of 25µm thickness (Made by Matsushita Electric Industrial Co., Ltd., product name: PGS sheet) is cut to a 10 cm square corresponding to the size of the electrode substrate.

### [Assembly]

(A) A film is formed by the carbon paste as a line with a dispenser on the upper side of the exposed transparent conductive layer provided between each of the porous titanium oxide films formed provided as a stripe. At this time, the carbon paste as a line is formed slightly separate from the lateral sides of both sides of the porous titanium oxide films.

(B) The applied carbon paste is dried at 120 °C to be a coating film with a slight tack property.
(C) A 10 cm square graphite sheet is adhered on the carbon paste coating film and the carbon paste is sintered at 400 °C with the graphite sheet and the carbon paste coating film being pressed in the vertical direction.
(D) The graphite sheet is cut in a stripe by the excimer laser apparatus corresponding to the shape of the porous titanium oxide film. Furthermore, the second conductive layer, which is to be a counter electrode, is formed by cutting also in a direction perpendicular to the stripe, and a dye-sensitized solar cell structure, which is electrically connected in series, is formed.
(E) The dye-sensitized solar cell structure is immersed for a day in pigment solution heated to 50 °C. Sensitizing dye (made by Solaronix SA, product name: Ruthenium535) is solved in a solvent made of the equal amounts of t-butanol and acetonitrile mixed to be 0.3 mM in concentration. The pigment is held in the porous titanium oxide film, and then cleaned by the acetonitrile.
(F) After applying hot melt additives (made by DU PONT-MITSUI POLYCHEMICALS CO., LTD., product name: HIMILAN) between each of the dye-sensitized solar cell structures (i.e. a slit formed in a direction of the stripes made of the transparent conductive film and the porous titanium oxide film), the back side glass plate is adhered by a heat press at 120°C.
(G) After filling the electrolyte from the opening provided in the back side glass plate, the opening is sealed by a UV hardening resin (made by ThreeBond Co., Ltd.).

As described above, the dye-sensitized solar cell module in accordance with the embodiment was produced. The module has the following features.
(1) Stress can be reduced since the graphite sheet which is to be a counter electrode and the titanium oxide porous electrode are not bonded with each other and they are freely slidable irrespective of each other.
(2) The film of the counter electrode does not need to be formed at the site; therefore a robust sheet with high conductivity can freely be selected.
(3) The carbon paste for bonding the working electrode with the counter electrode can not be used as a counter electrode sheet member due to a composition which contracts in the film forming process. However, since the carbon paste is made of only an extremely robust organic substance and a volatilization component, which is decomposed at a low temperature, it does not degrade the porous titanium oxide film. When a heat resistance resin component such as polyimide, silicon, alumina, or the like is included in the volatilization component, the porous titanium oxide film is significantly degraded.

### <Comparison example>

As a comparison example 1, a sample was made as follows.
(A) An electrode substrate formed with a plurality of transparent conductive films (first conductive layer) provided as stripes with a width of about 1 cm is formed by cleaning a 10 cm square glass substrate with FTO transparent conductive film (made by ASAHI GLASS CO., LTD., product name: A110U80R, surface resistivity: 10 Ω/sq) and forming a slit with a patch of about 1 cm using the excimer laser apparatus.

(B) A porous titanium oxide film of about 10 µm thickness is formed by forming a film with titanium oxide paste (made by Solaronix SA, product name: Ti-nanoxide D/sp) provided as a stripe of about 9 mm in width on the upper surface of the transparent conductive layer so as to expose a lateral border portion of the transparent conductive layer by the screen printing method and heating at 500 °C.

(C) In the same way, a film was formed in stripe on the porous titanium oxide film provided as a stripe by the screen printing method so as to slightly shift the titanium oxide paste for separator layer (titanium oxide and ethylcellulose are dissolved in terpineol) in the width direction, heated at 500 °C, and the second porous titanium oxide film was produced. At that time, the film thickness of two layers of the porous titanium oxide films was 20 µm.

(D) A film was formed as a line with the carbon paste on the porous titanium oxide film formed with a separator layer so as to further slightly shift in the same direction in which the second porous titanium oxide film was shifted by the dispenser.

(E) The carbon paste is heated at 450 °C to form a dye-sensitized solar cell structure which is electrically connected in series is formed.
(F) The dye-sensitized solar cell structure is immersed for a day in pigment solution heated to 50 °C. Sensitizing dye (made by Solaronix SA, product name: Ruthenium535) is solved in a solvent made of the equal amounts of t-butanol and acetonitrile mixed to be 0.3 mM in concentration. The pigment is held in the porous titanium oxide film, and then cleaned by the acetonitrile.

(G) After applying hot melt additives (made by DU PONT-MITSUI POLYCHEMICALS CO., LTD., product name: HIMILAN) between each of the dye-sensitized solar cell structures (i.e. a slit formed in a direction of the stripes made of the transparent conductive film and the porous titanium oxide film), the back side glass plate is adhered by a heat press at 120°C.
(H) After filling the electrolyte from the opening provided in the back side glass plate, the opening is sealed by a UV hardening resin (made by ThreeBond Co., Ltd.).

### <Comparison result>

20 samples for each of the Example 1 and the Comparison example 1 were produced and a conversion efficiency was measured under a condition of AM-1.5, 1 Sun, and an initial conversion efficiency and an initial average fill factor were evaluated. A heat cycle test between -40 °C and 60 °C and a drop test of 1 m were performed 20 times for each sample, the conversion efficiencies were measured, and a decreasing ratio of the conversion efficiency from the initial conversion efficiency was evaluated. It is defined such that the initial conversion efficiency greater than or equal to 5.0 % is acceptable, and greater than or equal to 80 % of the initial value is acceptable for the decreasing ratio of the conversion efficiency. Table 1 shows the evaluation test results. Here, the number of NG shown in Table 1 indicates the number of failure samples which did not meet the criteria above.

**[Table 1]**

| A heat cycle test between -40 °C to 60 °C and a drop test of 1 m were performed 20 times for each sample (the number of samples: 20 pieces) | | | |
|---|---|---|---|
| | The number of NG initial conversion efficiency | Initial average fill factor (∝ internal resistance) | the decreasing ratio of the conversion efficiency |
| Example 1 | 0 pieces | 61.3% | 1 pieces |
| Comparison example 1 | 2 pieces | 57.0% | 14 pieces |

20 samples for each of the Example 1 and the Comparison example 1 were produced and a conversion efficiency was measured under a condition of AM-1.5, 1 Sun, and an initial conversion efficiency and an initial average fill factor were evaluated. A heat cycle test between 95 °C to -40 °C was performed 100 times for each sample, the conversion efficiencies were measured, and a decreasing ratio of the conversion efficiency from the initial conversion efficiency was evaluated. It is defined such that the initial conversion efficiency greater than or equal to 5.0 % is acceptable, and greater than or equal to 80 % of the initial value is acceptable for the decreasing ratio of the conversion efficiency. Table 2 shows the evaluation test results. Here, the number of NG shown in Table 2 describes the number of failure samples which did not meet the criteria above.

**[Table 2]**

| A heat cycle test between 95 °C to -40 °C was performed 100 times for each sample (the number of samples: 20 pieces) | | | |
|---|---|---|---|
| | The number of NG initial conversion efficiency | Initial average fill factor (∝ internal resistance) | the decreasing ratio of the conversion efficiency |
| Example 1 | 0 pieces | 62.1% | 6 pieces |
| Comparison example 1 | 1 pieces | 58.3% | 19 pieces |

In producing the samples of the Example 1 and the Comparison example 1, relative to the electrodes before the pigments were held (corresponding to (D) to (E) of [Assembly] in the Example 1 and (E) to (F) in the Comparison example), a process of performing 20 heat cycle tests between 25 °C and 500 °C was added, and 20 samples for each of the Example 1 and the Comparison example 1 were produced. The conversion efficiency was measured under a condition of AM-1.5, 1 Sun, and an initial conversion efficiency and an initial average fill factor were evaluated. It is defined such that the initial conversion efficiency greater than or equal to 5.0 % is acceptable. Table 3 shows the evaluation test results. Here, the number of NG shown in Table 3 describes the number of failure samples which did not meet the criteria above.

**[Table 3]**

| 20 heat cycle tests between 25 °C and 500 °C were added in the production process (before the pigment was held) (the number of samples: 20 pieces) | | |
|---|---|---|
| | The number of NG initial conversion efficiency | Initial average fill factor (∝ internal resistance) |
| Example 1 | 0 pieces | 61.9% |
| Comparison example 1 | 20 pieces | 24.2% |

As other examples, instead of the graphite sheet for the counter electrode material in the Example 1, Ti foil (0.04 mm of thickness), in which a platinum film of 5 nm thickness is formed by a RF spatter apparatus, is used (Example 2). Also, Example 3 was made such that the graphite sheet was not cut in a direction perpendicular to the stripe. Examples 2 and 3 were evaluated.

20 samples for each of the Examples 2 and 3 were produced and a conversion efficiency was measured under a condition of AM-1.5, 1 Sun, and an initial conversion efficiency and an initial average fill factor were evaluated. A heat cycle test between -40 °C to 60 °C and a drop test of 1 m were performed 20 times for each sample, the conversion efficiencies were measured, and a decreasing ratio of the conversion efficiency from the initial conversion efficiency was evaluated. It is defined such that the initial conversion efficiency greater than or equal to 5.0 % is acceptable, and greater than or equal to 80 % of the initial value is acceptable for the decreasing ratio of the conversion efficiency. Table 4 shows the evaluation test results. Here, the number of NG shown in Table 4 describes the number of failure samples which did not meet the criteria above.

**[Table 4]**

| A heat cycle test between -40 °C to 60 °C and a drop test of 1 m were performed 20 times for each sample (the number of samples: 20 pieces) | | | |
|---|---|---|---|
| | The number of NG initial conversion efficiency | Initial average fill factor (∝ internal resistance) | the decreasing ratio of the conversion efficiency |
| Example 2 | 0 pieces | 62.9% | 2 pieces |
| Example 3 | 1 pieces | 60.5% | 4 pieces |

From the above described evaluation results, the dye-sensitized solar cell module in accordance with the present invention has low number of NG in the initial conversion efficiency or the decreasing ratio of the conversion efficiency and has high initial average fill factor. Also, it has an excellent durability relative to stress (an impact or the like during placement, a temperature change in the summer and or the winter, hail fall, transportation, or the like) during use.

### [INDUSTRIAL APPLICABILITY]

In accordance with the present invention, a dye-sensitized solar cell module and a production method thereof can be provided, which is capable of restraining a decrease in durability of a film of a counter electrode with regard to thermal expansion and contraction of each of the layers of the photoelectrode and the counter electrode due to the thermal history and to a bending or a distortion in each of the substrates of the transparent substrate and the back side substrate.

## Claims

1. A dye-sensitized solar cell module comprising:
a base material;
a back side plate provided so as to face the base material; and
a plurality of a dye-sensitized solar cells provided in parallel between the base material and the back side plate,
the dye-sensitized solar cell including:
a first conductive layer provided on the base material;
a second conductive layer provided on the back side plate so as to face the first conductive layer; and
a porous semiconductor layer provided between the first conductive layer and the second conductive layer, wherein
by electrically connecting the second conductive layer belonging to a first dye-sensitized solar cell with an adjacent first electrode layer which is the first conductive layer of another dye-sensitized solar cell adjacent to the first dye-sensitized solar cell, the plurality of dye-sensitized solar cells are electrically connected in series, and
an area of the second conductive layer overlapping the porous semiconductor layer seen from the back side plate is not bonded with the porous semiconductor layer or the back side plate.

2. The dye-sensitized solar cell module according to Claim 1, wherein
the second conductive layer is held in the dye-sensitized solar cell by an area of the second conductive layer except the overlapping area in the first conductive layer of the adjacent dye-sensitized solar cell being bonded with the first conductive layer of the adjacent dye-sensitized solar cell.

3. The dye-sensitized solar cell module according to Claim 2, wherein
the area of the second conductive layer except the overlapping area in the first conductive layer of the adjacent dye-sensitized solar cell is further bonded with the back side plate.

4. The dye-sensitized solar cell module according to any one of Claims 1 to 3, wherein
the second conductive layer is a conductive member provided as a film.

5. The dye-sensitized solar cell module according to any one of Claims 1 to 3, wherein
the second conductive layer is divided in a direction in which the plurality of the dye-sensitized solar cells is aligned.

6. The dye-sensitized solar cell module according to Claim 4, wherein
the second conductive layer is divided in a direction in which the plurality of the dye-sensitized solar cells is aligned.

7. The dye-sensitized solar cell module according to Claim 2 or 3, wherein
the second conductive layer is connected with the first conductive layer, which is electrically connected, via a conductive connection member.

8. A production method of a dye-sensitized solar cell module comprising:
preparing a base material and an electrode substrate provided with a plurality of a first conductive layers formed on a side of the base material;
forming a porous semiconductor layer on each of the conductive layers of the electrode substrate;
placing a second conductive layer above the porous semiconductor layer so as not to bond with the porous semiconductor layer;
bonding and electrically connecting the second conductive layer with an adjacent first electrode layer which is a first conductive layer of another dye-sensitized solar cell which is adjacent to a first dye-sensitized solar cell to which the second conductive layer belongs;
placing a back side plate on the second conductive layer so that an area of the second conductive layer placed above the porous semiconductor layer does not bond with the back side plate; and
filling the inside of the porous semiconductor layer with an electrolyte solution.

9. The production method of a dye-sensitized solar cell module according to Claim 8, wherein
the second conductive layer is a conductive member provided as a film.

10. The production method of a dye-sensitized solar cell module according to Claim 8 or 9, wherein
when bonding and electrically connecting the second conductive layer with the adjacent first electrode layer, a conductive connection member is provided on the adjacent first conductive layer so as to protrude upward from an upper surface of the porous semiconductor layer, and an end of the second conductive layer is bonded with an upper surface of the connection member.

11. The production method of a dye-sensitized solar cell module according to any one of Claims 8 to 10, wherein:
when placing the second conductive layer above the porous semiconductor layer, a conductive member provided as a film corresponding to a size of the electrode substrate is placed so as to cover a plurality of the porous semiconductor layers; and
when bonding and electrically connecting the second conductive layer with the adjacent first electrode layer, said one conductive member provided as a film is cut after an end portion of the area of said one conductive member provided as a film corresponding to the first dye-sensitized solar cell is bonded and electrically connected with the first conductive layer of adjacent another dye-sensitized solar cell.
